# EUROPEAN PATENT APPLICATION

(11) **EP 1 724 818 A2**
(43) Date of publication of application: **22.11.2006**
(21) Application number: 06114050.5
(22) Date of filing: 16.05.2006
(51) Int. Cl.: H01L 21/28, H01L 29/49, H01L 21/8234, H01L 21/8238

(54) **Method for forming fully silicided gates and devices obtained thereby**

(30) Priority: 16.05.2005 US 681821 P; 17.11.2005 JP 2005333307
(71) Applicant: INTERUNIVERSITAIR MICROELEKTRONICA CENTRUM ( IMEC), 3001 Leuven (BE); TEXAS INSTRUMENTS INCORPORATED, Dallas, Texas 75265 (US)
(72) Inventor: Kittl, Jorge Adrian, 1410, Waterloo (BE)
(74) Representative: pronovem

(57) **Abstract**

A method for manufacturing fully silicided (FUSI) gates and devices, in particular MOSFET devices, is described.

In a method of the invention, the silicide phase can be effectively controlled.

## Description

### Field of the invention

The present invention relates to semiconductor process technology and devices. In particular, the present invention relates to semiconductor devices with metallic gate electrodes formed by a reaction between a metal and a semiconductor material.

### Background

Metal gates are expected to replace partially silicided poly-Si gates in future complementary metal-oxide-semiconductor (CMOS) technology nodes, in order to eliminate poly-Si depletion issues. For this application, the work function (WF) is one of the most critical properties to be considered. Recently, there has been significant interest on the application of silicides as metal gate electrodes, and in particular, on NiSi fully-silicided (FUSI) gates.

From a processing point of view, it can be implemented as a variation of the Ni self-aligned silicidation process used in previous technology nodes in which the silicide is formed in the gate down to the dielectric interface, fully consuming the poly-Si film.

Ni-silicide appears as an attractive metal gate candidate that allows maintaining several aspects of the flows from previous generations (such as Si gate pattern and etch, and self-aligned silicide processes). A key property that has attracted attention to NiSi FUSI gates is the modulation of their effective work function on SiO₂ by dopants which may allow for tuning of the threshold voltage (Vₜ) of nMOS and pMOS devices without the need for two different metals. The integration and properties of Ni FUSI gates on high-k dielectrics is also of interest for advanced CMOS applications.

Good control of the WF and Vₜ of devices is an essential requirement for gate electrode applications. In order to assess the ability to control Vₜ for Ni FUSI gate processes and given the large number of silicide phases in the Ni-Si system, it is important to address (a) the ability to control the Ni-silicide phase at the dielectric interface, and (b) the work functions of different silicide phases (both for conventional and for high-K dielectrics).

Hence, there is a need for a method for manufacturing metal gate CMOS devices in which the work function and the threshold voltage of the metal gate electrode of each transistor type can be controlled in an easy and efficient way, independent of the geometry and/or dimensions of the transistor or of the gate dielectric used.

### Summary

The present invention relates to a method of manufacturing a fully-silicided-gate electrode in a semiconductor device, comprising the steps of:
- depositing a metal layer over a semiconductor layer of a gate stack,
- providing a first thermal budget to allow a partial silicidation of said semiconductor layer, whereby the silicide layer obtained has a ratio metal-to-semiconductor higher than 1,
- removing selectively the remaining, unreacted metal layer, and
- providing a second thermal budget to allow a full silicidation of said semiconductor layer.

Preferably, said semiconductor layer comprises (or consists of) silicon and/or germanium, more preferably comprises (or consists of) poly-silicon (poly-Si).

Preferably, said metal layer comprises (or consists of) any suitable refractory metal, noble metal, transition metal, or any combination thereof. More preferably, said metal layer comprises (or consists of) Ni.

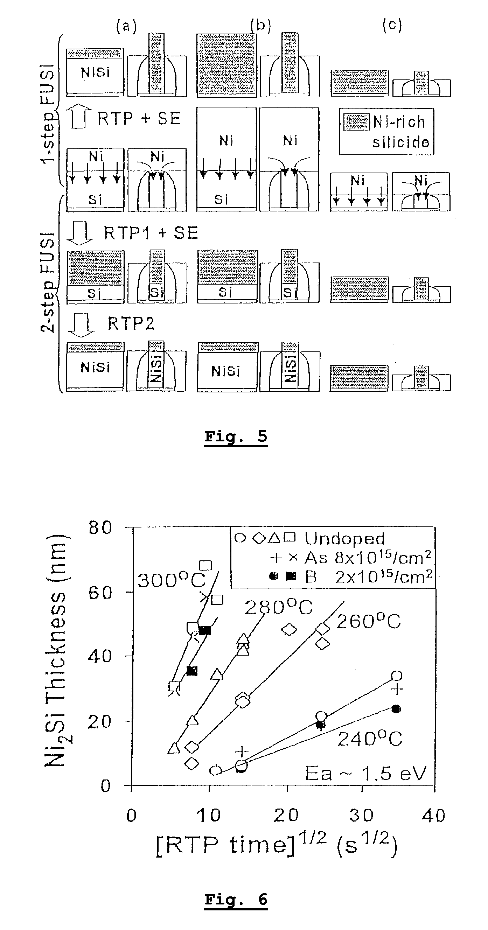

In a method according to the invention, said first thermal budget can be determined by a silicidation kinetics graph (such as the silicidation kinetics graph represented by figure 6) drawn up for each silicide phase, MₓS_{y}, envisaged in the partially silicided gate, wherein M represents said metal and S said semiconductor used, and wherein x and y are real numbers different from 0 and higher than 0.

Preferably, the step of providing said first thermal budget consists of an Rapid Thermal Processing (RTP).

Preferably, the step of providing said second thermal budget consists of an RTP.

Preferably, the step of removing said remaining metal layer consists of a selective etching.

In a preferred method according to the invention, said metal layer consists of Ni and said semiconductor layer consists of poly-Si. In particular, said first thermal budget is such that a Ni₂Si layer is grown, with a thickness comprised between 0,9 and 1,5 of the poly-Si thickness, whereby a NiSi FUSI gate is obtained. By drawing up a silicidation kinetics graph (such as the silicidation kinetics graph represented by figure 6) for Ni₂Si, the temperature and time period to apply as said first thermal budget can be determined.

More particularly, a method according to the invention for manufacturing a fully-silicided-gate electrode in a MOSFET device, comprises the steps of:
- depositing a nickel layer over a poly-Si layer of a gate stack,
- providing a first thermal budget to allow a partial silicidation of said poly-Si layer, whereby the silicide layer obtained has a ratio Ni/Si higher than 1,
- removing selectively the remaining, unreacted metal layer, and
- providing a second thermal budget to allow a full silicidation of said semiconductor layer.

Said first thermal budget can be determined by a silicidation kinetics graph drawn up for each silicide phase, NiₓSi_{y}, envisaged in the partially silicided gate, wherein x and y are real numbers different from 0 and higher than 0 and wherein 1<x/y≤3.

Preferably, said first thermal budget is such that a Ni₂Si layer is grown, with a thickness comprised between 0,9 and 1,5 of the poly-Si thickness, whereby a NiSi FUSI gate is obtained.

Preferably, in a method according to the invention, said poly-Si layer is upon a SiON or upon a HfSiON layer.

### Brief description of the drawings

Exemplary embodiments are illustrated in referenced figures of the drawings. It is intended that the embodiments and figures disclosed herein be considered illustrative rather than restrictive. Same numerals are used to refer to corresponding features in the drawings.

Figure 1 represents XRD spectra showing formation of NiSi, Ni₂Si and Ni₃Si by adjusting Ni to Si thickness ratio.

Figure 2 represents the increase in resistivity and silicide thickness with increasing Ni to Si thickness ratio.

Figure 3 represents CV curves for FUSI devices, showing larger V_{FB} shifts from NiSi to Ni₃Si on HfSiON (330 mV) than on SiON (100 mV).

Figure 4 represents the WF for the main Ni silicide phases. The large difference for NiSi between SiO₂ and HfSiON disappears for larger Ni contents indicating unpinning of the FL.

Figure 5 represents schematic processes showing 1-step and 2-step FUSI processes on wide and narrow gates, for varying Ni and Si thicknesses. Due to Ni diffusion from top of spacers, the effective Ni/Si ratio can be larger for narrow devices than for large structures.

Figure 6 represents Ni₂Si silicidation kinetics showing diffusion limited growth.

Figure 7 represents silicide growth rates for NiSi and Ni₂Si.

Figure 8 represents Rₛ vs. L showing linewidth effect for 60 nm Ni 1-step FUSI eliminated with 2-step FUSI.

Figure 9 represents TEM cross sections of narrow FUSI gates for 1-step and 2-step FUSI processes.

Figure 10 represents Vₜ roll-off for 1-step and 2-step Ni FUSI/HfO₂ processes. The kink seen for the 1-step process is due to transition from NiSi for long gate lengths to Ni rich silicide on short ones.

Figure 11 represents Vₜ roll-off for Ni FUSI/SiON processes. For t_{NI}/t_{Si}=0.6 (targeting NiSi), the 1-step process shows a kink corresponding to the transition from NiSi at long gate lengths to Ni rich silicide at short gate lengths. Ni₃Si and 2-step NiSi FUSI processes show smooth Vₜ roll-off to 30 nm gate lengths.

Figure 12 represents Vₜ roll-off for Ni FUSI/HfSiON showing scalability with smooth roll-off for Ni₃Si and 2-step NiSi FUSI processes.

Figure 13 represents Rₛ vs. RTP1 temperature for 2-step Ni FUSI process. The increase in Rₛ with increasing temperature for 50 nm gates is due to the transition from NiSi to Ni-rich silicide.

Figure 14 (a) represents a RTP1 process window for 2-step NiSi FUSI process. Process margins need to be added to account for process variations and silicide reaction non-uniformity (b) and (c).

Figure 15 represents XRD patterns of Ni-silicide on SiO₂ films for deposited Ni to poly-Si thickness ratios (t_{Ni}/t_{Si}) between 0.3 and 0.9.

Figure 16 represents RBS spectra of Ni-silicide on SiO₂ films for deposited Ni to poly-Si thickness ratios (t_{NI}/t_{Si}) between 0.6 and 0.9.

Figure 17 represents a cross-section TEM of Ni FUSI gate stack showing bi-layer structure. NiSi was identified in the lower layer by Fourier-transformed high-resolution images. EDX showed a higher Ni/Si composition ratio for the top layer.

Figure 18 represents RBS spectra of Ni-silicide on SiO₂ films for deposited Ni to poly-Si thickness ratios (t_{Ni}/t_{Si}) of 0.6 and 1.1 (1 MeV ⁴He⁺⁺, 160°).

Figure 19 represents XRD patterns of Ni-silicide on SiO₂ films for deposited Ni to poly-Si thickness ratios (t_{Ni}/t_{Si}) between 0.6 and 1.7. Results for different silicidation processes are shown for selected thickness ratios (LT and HT indicate lower and higher temperature processes respectively).

Figure 20 represents RBS spectra of Ni-silicide on SiO₂ films for deposited Ni to poly-Si thickness ratios (t_{Ni/}t_{Si}) of 0.6 to 1. 7 (2 MeV ⁴He⁺⁺, 160°).

Figure 21 represents flat band voltage vs. EOT for (a) NiSi/SiO₂, (b) NiSi/HfSiON/SiO₂ and (c) Ni₂Si/SiO₂ capacitors showing the effect of dopants.

Figure 22 represents CV curves comparing NiSi and Ni₃Si FUSI gates for (a) SiON and (b) HfSiON dielectrics.

Figure 23 schematically illustrates a method according to the present invention.

Figure 24 shows XRD (Cu K_{α} radiation) characterization of Ni silicide films as function of RPT1 temperature according to an example.

Figure 25 shows the reacted nickel to silicon ratio of Ni silicide films as function of the RPT1 temperature according to an example.

### Detailed description

In patterned devices, in particular for narrow lines, typically less than 100nm, the metal / semiconductor ratio is not well defined: the metal from top of spacers and surrounding areas can diffuse and react with the semiconductor in the gate, to increase the effective metal / semiconductor ratio.

A new method for manufacturing a fully-silicided-gate device is described that can eliminate the linewidth dependence existing in previous silicidation methods.

A method according to the invention for manufacturing a fully-silicided-gate in a semiconductor device comprises the steps of:
- depositing a metal layer over a semiconductor layer of a gate stack,
- providing a first thermal budget (selecting temperature and/or time) to allow a partial silicidation of said semiconductor layer,
- removing selectively the remaining, unreacted metal layer, and
- providing a second thermal budget to allow a full silicidation of said semiconductor layer.

In a method according to the invention, said metal layer can be of any metal(s) preferably capable of diffusing into the underlying semiconductor material and suitable for metal gate electrodes. More particularly, said metal layer can comprise or consists of a refractory metal such as tantalum or tungsten, a noble metal such as Pt, a near noble metal such as Ni, a transition metal such as Ti, or any combination of two or more of these metals.

Said semiconductor layer can be of any material(s) suitable for metal gate electrodes. More particularly, said semiconductor layer can comprise or consists of Si, Ge or a mixture thereof.

The first thermal step consists of providing a temperature (also referred to as thermal energy), T°1, within a determined period of time. T°1 is preferably smaller than the temperature applied in the second thermal step, T°2. Preferably, said first thermal step consists of a Rapid Thermal Processing (RTP1)step.

Preferably, said temperature is applied within a period of time varying between about 30 seconds and about 60 seconds.

The second thermal step consists of providing a temperature, T°2, preferably higher than T°1, within a determined period of time, preferably within a period of time varying between about 30 seconds and about 60 seconds. Preferably, said second thermal step consists of a Rapid Thermal Processing (RTP2) step.

Limiting T°1 and the period of time aims at controlling the reaction between said metal and said semiconductor such that a metal-rich silicide layer is grown while a certain thickness of said semiconductor layer remains unreacted.

In the framework of the present invention, the terms "silicide", "silicided", "silicidation" can refer to the reaction between a metal and silicon, but is not intended to be limited to silicon. For instance, the reaction of a metal with Ge, or any other suitable semiconductor material, may still be referred to as silicidation.

In the framework of the present invention, the term "metal-rich silicide" refers to the material resulting from the reaction between said metal and said semiconductor, wherein the ratio metal-to-semiconductor is larger than 1.

The silicide phase (also referred to as metal-semiconductor phase) can be represented by the formula MₓS_{y}, wherein M represents the metal, S represents the semiconductor and wherein x and y are integers or real numbers different from 0. In a metal-rich silicide (phase), x/y is larger than 1.

For selected metal-semiconductor alloys, i.e. silicides, the work function thereof may depend on the specific phase in which the alloy is formed. Hence, the suitability of such metal-semiconductor combinations as gate electrode for one type of transistor depends on which phase of this combination can be formed for this type of transistor. Said specific phase is to be formed at least at the bottom part of the gate electrode, the last few nanometers of the gate electrode (e.g. the last nanometer, or the last 2, 3, 4, 5, 10 nanometers or even more), i.e. at least at the part which is the nearest to the gate dielectric, also referred to in the present invention as the "interface". In other words, in the context of the present invention, the term "interface", when referring to the silicide phase of the gate electrode, refers to the bottom part of the gate electrode (which is the nearest to the gate dielectric), of few nanometers thickness, e.g. between about 1 nm and about 10 nm, preferably between about 1 nm and about 5 nm.

For example, when the metal deposited is Ni and the semiconductor is poly-Si, several phases can result from their reaction, such as NiSi₂, NiSi, Ni₂Si, Ni₃₁Si₁₂, Ni₃Si, etc. For instance, Ni₂Si, Ni₃₁Si₁₂, Ni₃Si are Ni-rich silicides.

More particularly, having regard to nickel silicide, for metal-rich phases, such as Ni₂Si, Ni₃Si₂, Ni₃₁Si₁₂, or Ni₃Si, the ratio x/y is higher than 1 and preferably less than or equal to 3 (i.e. 1<x/y≤3), while for metal-poor phases, such as NiSi or NiSi₂, the ratio x/y is higher than 0 and less than or equal to 1 (i.e. 0<x/y≤1).

Indeed, said metal-rich silicide layer obtained after said first thermal step has a ratio metal-to-semiconductor (x/y) larger than 1.

After the step of removing the remaining (unreacted) metal layer, preferably in a selective etching step, said metal-rich silicide layer can act as the only source of metal during said second thermal step to fully silicide the semiconductor layer.

In other words, the total amount of metal in the fully silicided gate is the amount of metal that is stored in said metal-rich silicide layer after the step of removing the remaining metal. Thus the only metal available for the reaction in the second thermal step is the amount of metal incorporated in said metal-rich silicide layer. In the second thermal step only a redistribution of this fixed amount of metal occurs.

By selecting the metal-semiconductor phase (MₓS_{y}) envisaged for the fully silicided gate to be manufactured, and the dimension of that fully silicided gate, the total amount of metal present in said fully silicided gate to be manufactured can thus be determined.

Said determined total amount of metal is also the amount of metal that is to be incorporated in the partially silicided semiconductor layer (obtained after said first thermal step), which is the only source of metal after the removal of the remaining, unreacted metal layer.

In order to obtain the desired amount of metal in said partially silicided semiconductor layer, the metal diffusion rate, in the reaction metal / semiconductor, is controlled in a method of the invention, by providing a thermal budget (T°1 and time) based on a silicidation kinetics graph pre-established for each silicide phase.

In other words, T°1 and time parameters can be determined for each silicide phase by establishing a silicidation kinetics graph, such as the Ni₂Si silicidation kinetics graph drawn up and represented in figure 6.

A method of the invention can thus further comprise the step of establishing a silicidation kinetics graph for determining T°1 and the time to be applied in said first thermal step.

The present invention will be described herein after with respect to particular embodiments and with reference to certain drawings, but the invention is not intended to be limited thereto.

In a preferred embodiment, the metal layer consists of Ni and the semiconductor material consists of poly-Si.

In a method according to the invention, the effective Ni/Si ratio is controlled by limiting the first thermal budget, growing a Ni-rich silicided layer, wherein the poly-Si layer is not fully consumed. The unreacted Ni on top of the Ni-rich silicided layer (if any), on the spacers and surrounding areas are then removed, preferably in a selective etching step. A second thermal budget is applied to fully silicide the gate.

The first thermal step consists of providing a temperature T°1 during a period of time, both determined on the basis of a silicidation kinetics graph established for each silicide phase.

The second thermal step consists of providing a temperature T°2 during a period of time, also determined on the basis of a silicidation kinetics graph.

For instance, when a NiSi fully silicided gate is envisaged, the Ni-rich phase in the partially silicided layer can be any NiₓSi_{y} phase(s), wherein x/y is larger than 1, preferably equal or larger than 2.

For example, when the silicide envisaged is a NiₓSi_{y} silicide with 0<x/y≤1, preferably with x/y=1 (or with x/y substantially equal to 1), the metal-rich silicide in the partially silicided layer can be a NiₓSi_{y} silicide with x/y ≥ 2 (more particularly with 2≤x/y≤3).

More particularly, when a NiSi fully silicided gate is envisaged, the Ni-rich phase in the partially silicided layer can be Ni₂Si and/or Ni₃Si₂.

In a particular embodiment where the Ni-rich phase is Ni₂Si, T°1 and the time period of the first thermal step are determined on the basis of figure 6.

T°1 can be comprised between about 240°C and about 700°C, is preferably smaller than 500°C, more preferably comprised between about 240°C and 350°C.

Preferably, T°1 is applied during a period of time varying between about 30 seconds and about 60 seconds.

Preferably, said first thermal step consists of a Rapid Thermal Processing (RTP1).

T°2 can be comprised between about 350°C and about 900°C, is preferably higher than 500°C, more preferably comprised between 500°C and about 850°C.

Preferably, T°2 is applied during a period of time varying between about 30 seconds and about 60 seconds.

Preferably, said second thermal step consists of a Rapid Thermal Processing (RTP2).

In a method according to the invention, the effective (reacted) Ni/Si ratio is controlled by limiting the RTP1 thermal budget, growing a Ni-rich silicided that does not fully consume the poly-Si thickness. Excess Ni and Ni films on top of spacers / surrounding areas are then removed in the selective etch step. A second RTP step at a higher temperature is then used to grow NiSi, fully siliciding the gates.

The present invention can also be described as follows.

We demonstrate for the first time, the scalability of NiSi and Ni₃Si FUSI gate processes down to 30 nm gate lengths, with linewidth independent phase and Vt control.

We show that 1-step FUSI is inadequate for NiSi FUSI gates, because it results in incomplete silicidation at low thermal budgets or in a linewidth dependent Ni silicide phase, inducing Vₜ shifts at higher thermal budgets.

We show that Vₜ and WF shifts are larger on high-K (HfO₂ (250 mV) or HfSiON (330mV)) than on SiON (110mV) and report Fermi level unpinning for Ni-rich FUSI on high-K.

In contrast, we demonstrate the scalability of Ni₃Si FUSI, with no phase control issues, and report HfSiON Ni₃Si FUSI PMOS devices with Vₜ= -0.33 V.

Lastly, we show that, for NiSi, phase control down to narrow gate lengths can be obtained with a 2-step FUSI process.

Ni FUSI gates have recently attracted attention as metal gate candidates for scaled CMOS technologies (Cf. B. Tavel et al., IEDM Tech. Dig., 825 (2001); J. Kedzierski et al.,IEDM Tech. Dig., 247 (2002), 441 (2003); K. G. Anil et al., Symp. VLSI Tech., 190 (2004); A. Veloso et al., IEDM Tech. Dig., 855 (2004); K. Takahashi et al., IEDM Tech. Dig., 91 (2004)).

NiSi, NiSi₂ and Ni₃Si have been studied as possible gate materials. Due to its high nucleation temperature, NiSi₂ is less attractive for integration into self-aligned FUSI gate processes. The scalability of Ni FUSI gate processes to small gate lengths critical for advanced CMOS applications has not yet been addressed in detail, and is the focus of this work.

MOSFET devices with Ni FUSI gates (SiON, HfSiON and HfO₂) were fabricated using a self-aligned process with independent silicidation of the source/drain (S/D) and the poly-Si gate using a CMP approach as described in K. G. Anil et al., Symp. VLSI Tech., 190 (2004) and in A. Veloso et al., IEDM Tech. Dig., 855 (2004). Different Ni/Si ratios were used to obtain the different Ni silicide phases and study their formation as function of gate length. Physical characterization included TEM, SEM, RBS and XRD (RBS and XRD only for blanket films).

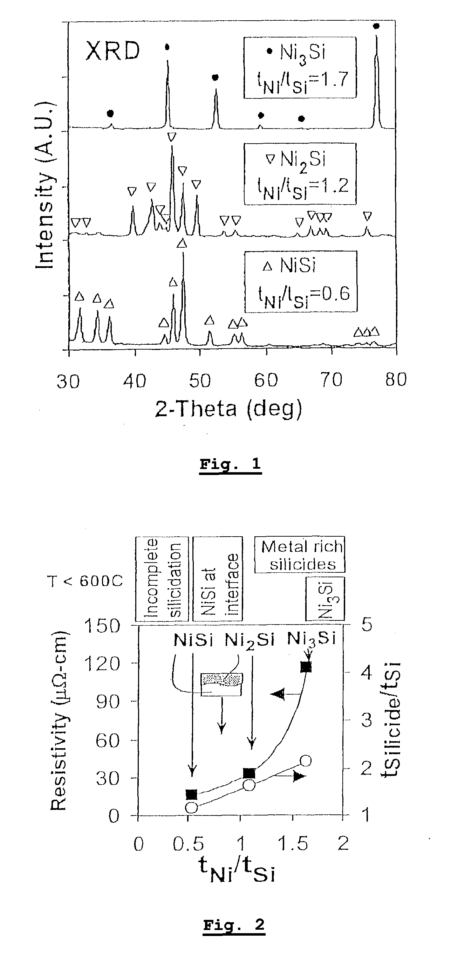

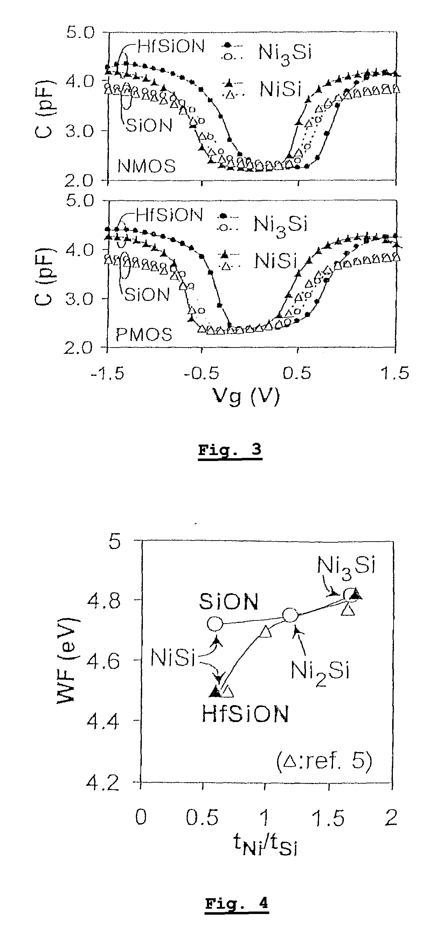

For blanket Ni films on poly-Si/dielectric stacks, the silicide phase can be effectively controlled by the Ni/Si thickness ratio (t_{Ni}/t_{Si}), when sufficient thermal budgets are used to drive the reaction to completion (Figs. 1, 2). NiSi, Ni₂Si and Ni₃Si phases were found for t_{Ni}/t_{Si} = 0.6, 1.2 and 1.7, respectively (Fig. 1). Since Ni silicides have limited composition range, mixed-phase films are formed between the stoichiometric ratios (with Ni₃Si₂ and Ni₃₁Si₁₂ also able to grow at low temperatures). NiSi₂ grows by a nucleation-controlled process and does not form uniformly below 600C, so that incomplete silicidation is seen for t_{Ni}/t_{Si} <0.5. For 0.6< t_{Ni}/t_{Si}<1, stacks with NiSi at the bottom and Ni-rich silicide layers on top are formed. For t_{Ni}/t_{Si}>1.7 Ni₃Si is the stable phase, and the excess Ni is removed in the selective etch step. The resistivity and thickness of the silicide films increase with increasing Ni/Si ratio (Fig. 2). CV measurements performed on FUSI devices showed larger V_{FB} shifts with change in Ni/Si composition ratio for HfSiON than for SiON (330 and 100 mV respectively, between NiSi and Ni₃Si, Fig. 3). WFs for the most relevant Ni silicide phases are shown in Fig. 4. A significant increase in WF with increasing Ni/Si ratio is observed for HfSiON devices, with only a milder change seen for SiO₂. The difference in NiSi WF observed between HfSiON and SiON, is attributed to Fermi level pinning on high-K devices. This difference disappears for Ni-rich silicides, suggesting the unpinning of the FL.

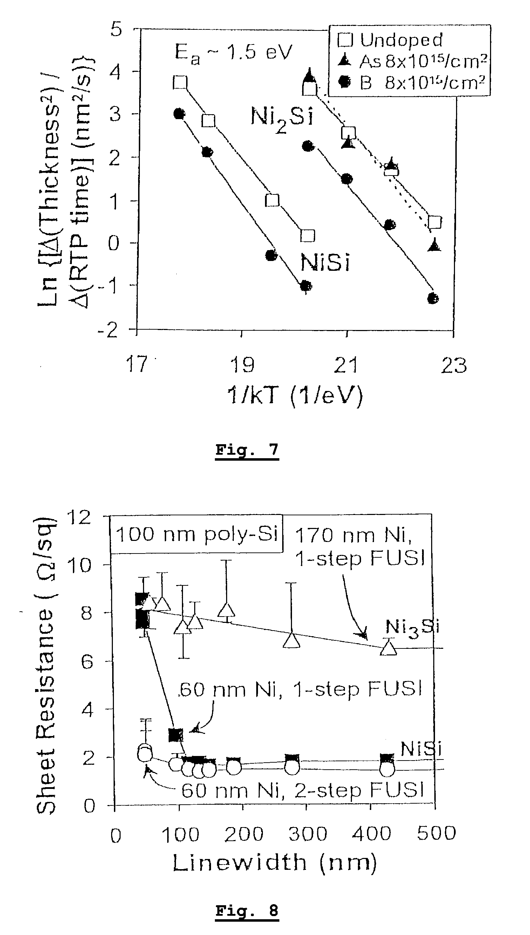

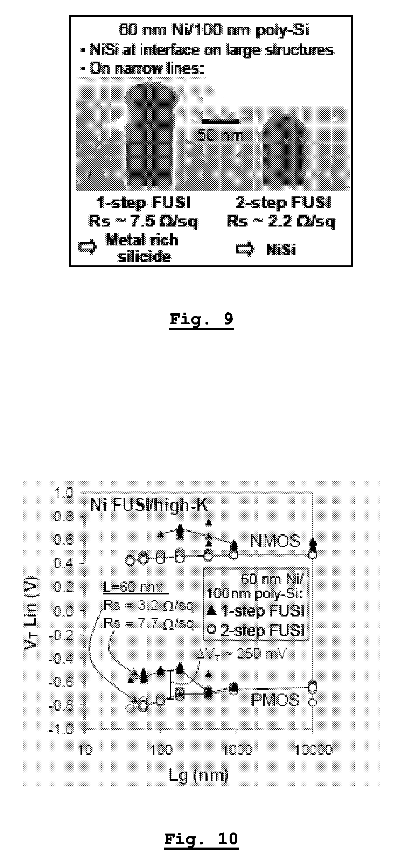

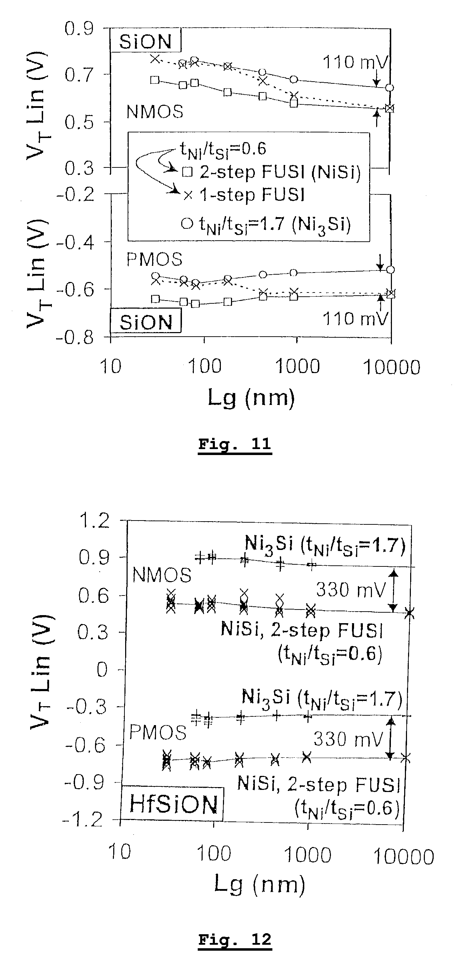

On patterned devices, the story is quite different. For narrow lines, the Ni/Si ratio is not well defined: Ni from top of spacers and surrounding areas can diffuse and react with poly-Si in the gate to increase the effective Ni/Si ratio (Fig. 5). To understand silicidation of narrow gates, we consider the Ni silicide phase sequence. Ni₂Si grows at low temperatures by Ni diffusion-limited kinetics (Fig. 6), while NiSi growth follows at higher temperatures with same type of kinetics (Fig. 7), only if available Ni is fully consumed and poly-Si is not. If the Ni supply is not limited, the reaction reaches completion with full Ni₃Si silicidation. As a consequence, a FUSI linewidth-effect is found for conventional 1-step FUSI processes. Using conditions developed for blanket films (60 nm Ni/100 nm poly-Si, 520C 30s RTP), a transition from full silicidation with NiSi at large gate lengths to full silicidation with Ni-rich silicide at 50 nm gate lengths was found, with the corresponding increase in sheet resistance and silicide thickness (Figs. 8 and 9). The sheet resistance of small gate lengths corresponds to Ni₃Si (Fig. 8). The key negative implication of this is that devices fabricated with this process show kinks in the Vₜ roll-off characteristics (Figs. 10, 11), consistent with a transition from NiSi to Ni₃Si with decreasing gate length. The kink is of ~250 mV on HfO₂ and of ~110 mV on SiON, consistent with the difference in WF between NiSi and Ni₃Si. The gate lengths at which the transition occurs depends on the thermal budget used (of magnitude of the Ni-rich silicide thickness grown at that thermal budget) and can also depend on details of the geometry (spacer height, etc.). A split of Vₜ showing a bi-modal distribution that correlates well with RS values (low Vₜ-high RS on PMOS) was observed at the transition gate length. In contrast, for a Ni/Si ratio targeting Ni₃Si (t_{Ni}/t_{Si}=1.7), no phase control issues were observed and Vₜ roll-off characteristics are smooth (Figs. 11, 12). Scalability with good phase and Vₜ control down to 30 nm gate lengths for Ni₃Si is demonstrated (Fig. 11). PMOS Vₜ= -0.33 V was obtained for Ni₃Si on HfSiON making it an attractive system. Vₜ values for the t_{Ni}/t_{Si}=0.6 1-step process (NiSi on large structures) and t_{Ni}/t_{Si}=1.7 (Ni₃Si) process are seen to merge at small gate lengths (Fig. 11), further confirming the formation of Ni rich silicide at small gate lengths in the 1-step FUSI process.

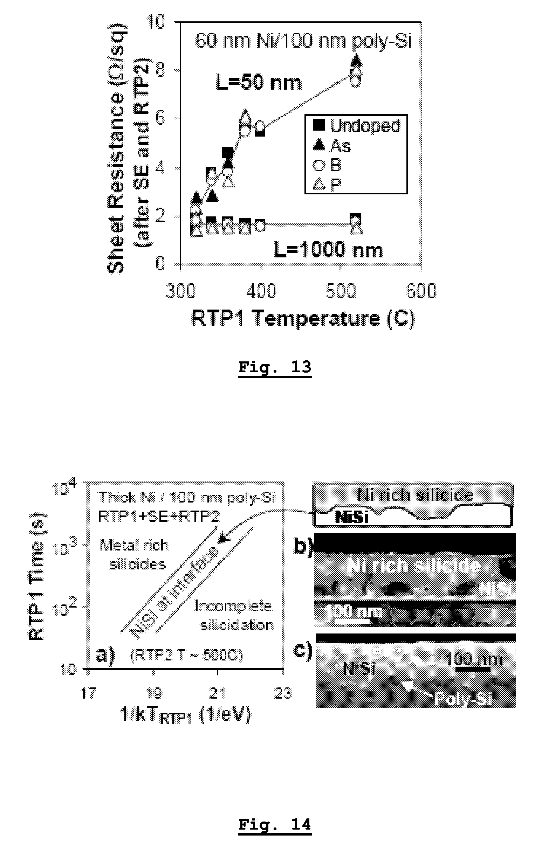

To solve the linewidth dependence of NiSi FUSI, a 2-step NiSi FUSI process (Fig. 5) was developed. The effective (reacted) Ni/Si ratio is controlled by limiting the RTP1 thermal budget, growing a Ni-rich silicide that does not fully consume the poly-Si thickness. Excess Ni and Ni films on top of spacers/surrounding areas are then removed in the selective etch step. A second RTP step at a higher temperature is then used to grow NiSi, fully siliciding the gates. Fig. 13 shows the effect of RTP1 temperature on sheet resistance of 50 nm and 1000 nm gates for 60nm Ni/100 nm poly-Si, showing the convergence of RS values with decreasing RTP1 temperature, corresponding to the transition from Ni-rich to NiSi on 50 nm gates.

In the 2-step FUSI process, the RTP1 thermal budget needs to be controlled such that the grown Ni₂Si layer has a thickness between 0.9 and 1.5 of the poly-Si thickness, to avoid incomplete silicidation and full silicidation with Ni-rich silicide respectively. The RTP1 process window estimated from Ni₂Si kinetic data (Figs. 6 and 7) is shown in Fig. 14. Margins for process variations and the intrinsic non-uniformity of silicidation need to be taken into account, making the process window ≤ 20 C. Figs. 8 and 9 show that a 2-step NiSi FUSI process can eliminate the linewidth dependence, allowing the growth of NiSi on large and small structures. Smooth Vₜ roll-off for the 2-step NiSi FUSI process further confirms that NiSi can be maintained to small gate lengths (Figs. 11, 12).

In this work, for the first time, scalability of NiSi and Ni₃Si FUSI gate processes was demonstrated to 30 nm gate lengths and its underlying mechanisms discussed in detail. For Ni-rich silicides (Ni₃Si), the same WF values (4.8 eV) are observed on SiON and HfSiON, suggesting unpinning of the Fermi level for HfSiON devices. A very attractive Vₜ= -0.33V is thus obtained for those devices with a scalable process. Smooth Vₜ roll-off characteristics and elimination of narrow line effect were also shown for a 2-step NiSi FUSI process.

The Ni-silicide phases and morphology in Ni fully silicided gates were investigated for varying deposited Ni to Si thickness ratios and rapid thermal processing conditions. The presence of NiSi₂, NiSi, Ni₃Si₂, Ni₂Si, Ni₃₁Si¹² and Ni₃Si as predominant phases was observed for increasing Ni to Si thickness ratios. In most samples typically two of these phases were detected by X-ray diffraction. No secondary phases were detected on Ni₃Si samples (Ni/Si thickness ratio ~1.7). For samples targeting NiSi as gate electrode, RBS and TEM analysis confirmed a layered structure with NiSi at the interface and a Ni-rich silicide layer (Ni₂Si, Ni₃Si₂) on top. Process conditions were determined for formation of gate electrodes for NiSi, Ni₂Si and Ni₃Si. Only small changes in flat-band voltage or work function were found between these phases on SiO₂ or SiON for undoped samples. While significant changes in work function with dopants were observed for NiSi on SiO₂, little or no effects were found for NiSi on HfSiON (suggesting Fermi-level pinning) and for Ni₂Si on SiO₂. An increase of > 300 mV was found from NiSi to Ni₃Si on HfSiON, suggesting unpinning of the Fermi-level with the Ni-rich silicide.

Metal gates are expected to replace partially silicided poly-Si gates in future complementary metal-oxide-semiconductor (CMOS) technology nodes, in order to eliminate poly-Si depletion issues. For this application, the work function (WF) is one of the most critical properties to be considered. Recently, there has been significant interest on the application of silicides as metal gate electrodes, and in particular, on NiSi fully-silicided (FUSI) gates (Cf. M. Qin, V. M. C. Poon and S. C. H. Ho, J. Electrochem. Soc., 148, (2001) 271; J. Kedzierski, D. Boyd, P. Ronsheim, S. Zafar, J. Newbury, J. Ott, C. Cabral Jr., M. Ieong and W. Haensch, IEDM Tech. Dig., (2003) 315; J. A. Kittl, A. Lauwers, O. Chamirian, M. A. Pawlak, M. Van Dal, A. Akheyar, M. De Potter, A. Kottantharayil, G. Pourtois, R. Lindsay and K. Maex, Mater. Res. Soc. Symp. Proc., 810, (2004) 31; K. G. Anil, A. Veloso, S. Kubicek, T. Schram, E. Augendre, J. -F. de Marneffe, K. Devriendt, A. Lauwers, S. Brus, K. Henson and S. Biesemans, Symp. VLSI Tech. Dig., (2004) 190.).

From a processing point of view, it can be implemented as a variation of the Ni self-aligned silicidation process used in previous nodes in which the silicide is formed in the gate down to the dielectric interface, fully consuming the poly-Si film. Ni-silicide appears as an attractive metal gate candidate that allows maintaining several aspects of the flows from previous generations (such as Si gate pattern and etch, and self-aligned silicide processes). A key property that has attracted attention to NiSi FUSI gates is the modulation of their effective work function on SiO₂ by dopants, which may allow for tuning of the threshold voltage (Vₜ) of NMOS and PMOS devices without the need for two different metals. The integration and properties of Ni FUSI gates on high-k dielectrics is also of interest for advanced CMOS applications.

Good control of the WF and Vₜ of devices is an essential requirement for gate electrode applications. In order to assess the ability to control Vₜ for Ni FUSI gate processes and given the large number of silicide phases in the Ni-Si system (Cf. A. Nicolet, S. S. Lau, in N. G. Einspruch and G. B. Larrabee (eds.), VLSI Electronics: Microstructure Science, Vol. 6, Ch. 6, Academic Press, New York (1983)), it is important to address a) the ability to control the Ni-silicide phase at the dielectric interface, and b) the work functions of different silicide phases (both for conventional and for high-K dielectrics). A study of these key materials issues is presented in this work.

Ni/poly-Si/dielectric stacks were deposited on (100) Si wafers, for varying film thicknesses, in the 30-170 nm and 60-100 nm ranges for Ni and Si films respectively. Dielectric films used in this study included SiO₂, SiON, HfSiON and HfSiON/SiO₂ stacks of varying thicknesses with equivalent oxide thickness (EOT) in the 1-20 nm range. Samples were reacted by rapid thermal processing (RTP) to form silicide films at temperatures in the 280-850 °C range, typically for 30 to 60 s. A wet etch used in self-aligned Ni-silicide processes (diluted sulfuric-peroxide solution) was subsequently performed. In some samples a second RTP anneal step was performed after the selective etch. Samples were characterized by X-ray diffraction (XRD) using Cu-K_{α} radiation, transmission electron microscopy (TEM), scanning electron microscopy (SEM) and Rutherford backscattering spectrometry (RBS). Patterned fully silicided gate devices were also fabricated for electrical characterization, using a chemical-mechanical polishing (CMP) flow as described in reference [4] or a conventional flow (the latter used only for fabrication of capacitors overlapping isolation). Ion implantation was performed on selected samples after poly-Si deposition, with some of these samples receiving an activation anneal.

### Ni-silicide phases in fully silicided gates.

Several silicide phases can be formed in the Ni-Si system. For the reaction of a thin Ni film with a Si-substrate, Ni-rich phases form first at low temperatures (Cf. A. Nicolet, S. S. Lau, in N. G. Einspruch and G. B. Larrabee (eds.), VLSI Electronics: Microstructure Science, Vol. 6, Ch. 6, Academic Press, New York (1983); and C. Lavoie, F. M. d'Heurle, C. Detavernier and C. Cabral Jr., Microelectronic Engineering, 70, (2003) 144).

The presence of Ni₃₁Si₁₂ has been reported at early stages of the reaction, followed by formation of Ni₂Si. Ni₂Si is generally the predominant phase at low temperatures and early stages of the reaction, forming a layer that grows by diffusion-limited kinetics. At higher temperatures and as Ni is consumed, NiSi nucleates and grows also by diffusion-limited kinetics. The presence of Ni₃Si₂ has also been reported during early stages of the reaction, before nucleation of NiSi. The formation of the different Ni-rich silicide phases can also depend on film thickness and thermal history (ramp rates, etc.) during the reaction. As the reaction proceeds for the case of a Nifilm on a Si substrate, NiSi grows fully consuming the Ni-rich silicides. NiSi₂ nucleates and grows at higher temperatures.

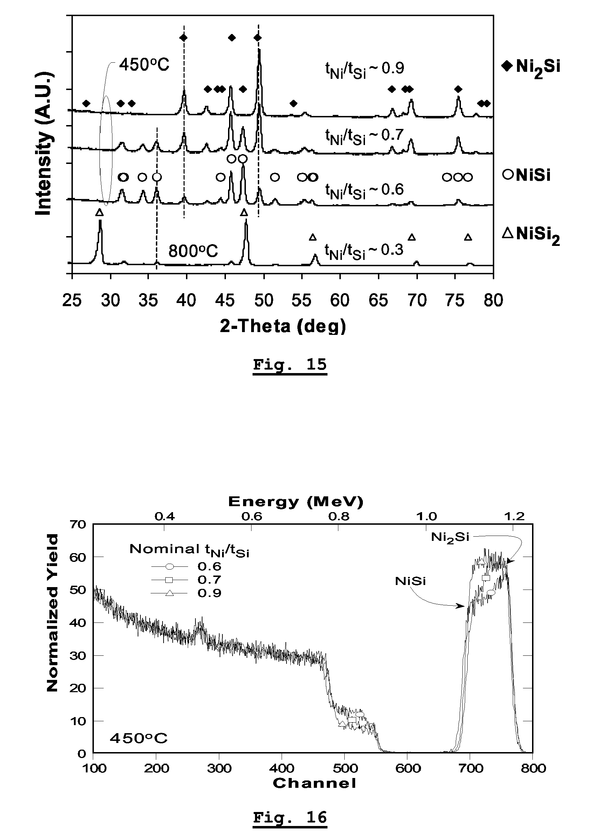

For Ni FUSI gate applications, deposited Ni films are reacted with either amorphous or polycrystalline Si films of limited thickness, deposited on top of a dielectric. The deposited Ni thickness to Si thickness ratio (t_{Ni}/t_{Si}) controls (in combination with the thermal history) the reacted Ni/Si ratio and phases obtained. It is essential for gate electrode applications that the silicide phase at the dielectric interface be well controlled, in order to ensure good control of the Vₜ of devices. The phases and morphology after full silicidation for varying t_{Ni}/t_{Si} ratios and thermal processes were investigated, in order to assess and identify conditions for formation of gates with a controlled silicide phase at the dielectric interface. NiSi₂ films with NiSi as secondary phase (as determined by XRD) were obtained for t_{Ni}/t_{Si} ~ 0.30-035 at 800 °C (Fig. 15). For applications in self-aligned silicide processes, the nucleation-controlled growth mechanism of NiSi₂ and its high nucleation temperature make it a less appealing candidate. If processing temperatures are kept below the nucleation temperature of NiSi₂, a minimum t_{Ni}/t_{Si} ratio of ~0.55 is required to allow full silicidation of the gate with NiSi. A larger t_{Ni}/t_{Si} ratio (e.g. 0.6) is desirable, however, to ensure full silicidation and prevent the presence of Si grains at the dielectric interface, allowing for possible process variations in deposited film thickness. As a result, when targeting NiSi as gate electrode material, bi-layer silicide films are typically obtained with NiSi at the bottom and a Ni-rich silicide on top (Figs. 15 to 17). The thickness of each layer depends on the Ni/Si ratio, with a larger proportion of Ni-rich silicide as the ratio is increased (Figs. 15 and 16). The phases present in the upper Ni-rich silicide layer can depend on the Ni/Si ratio chosen and on the thermal history. For samples with deposited Ni thickness of ~50-70 nm and varying poly-Si thickness with t_{Ni}/t_{Si} ratios in the ~0.6 to 0.9 range and reacted at 450 °C, the main phases observed by XRD are NiSi and Ni₂Si (Fig. 15), with NiSi and Ni₂Si as the bottom and top layers respectively as indicated by analysis of the RBS spectra (Fig. 16).

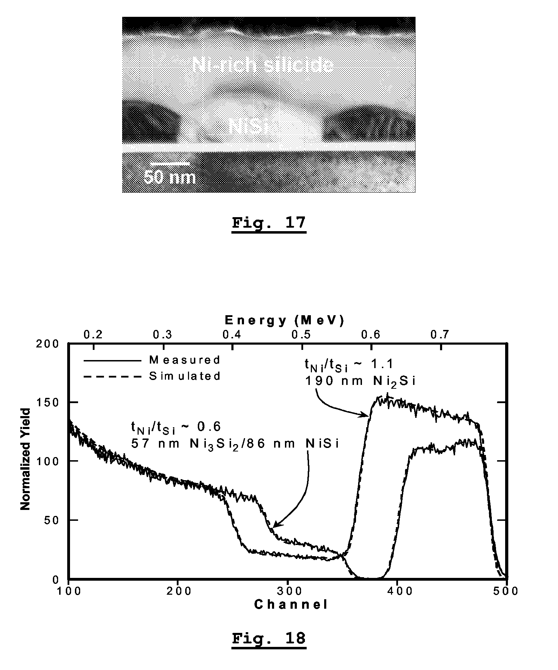

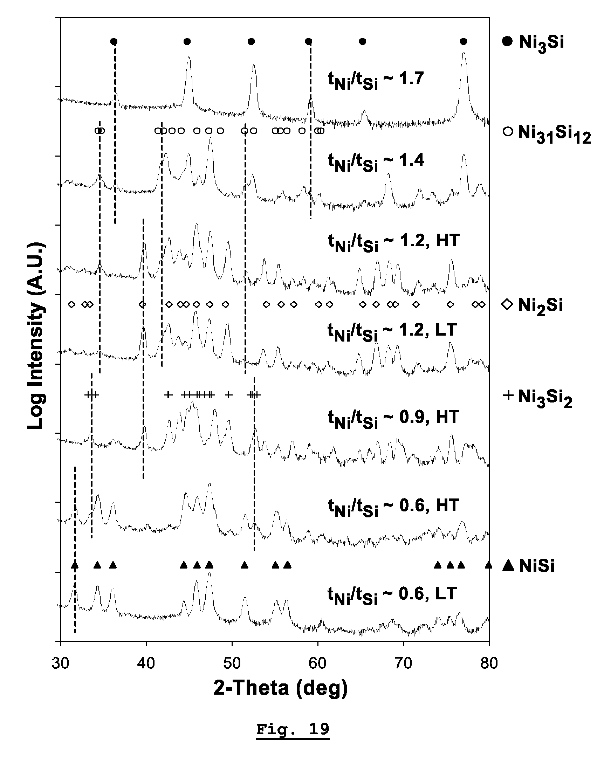

Characterization of bi-layer samples with deposited t_{Ni}/t_{Si} ~ 0.6 by scanning TEM (STEM) energy dispersive X-ray (EDX) analysis was performed for varying processing conditions. The ratio of Ni content (x in NiₓSi) from the top layer to the bottom layer (x_{top layer}/x_{bottom layer}) was found to be in the ~1.3 to 2 range, suggesting that Ni₃Si₂ and/or Ni₂Si may be present in the top layer, depending on processing conditions. RBS analysis also suggested that a bi-layer structure with Ni₃Si₂ as top layer and NiSi as bottom layer can be obtained (Fig. 18). We note, however, that RBS analysis can only provide information on the average composition vs. depth, and cannot distinguish between pure phases and phase mixtures. The presence of Ni₃Si₂ as secondary phase was confirmed by XRD analysis of NiSi samples formed from deposited t_{Ni}/t_{Si} ~ 0.6 by reaction at higher temperatures (HT); see Fig. 19.

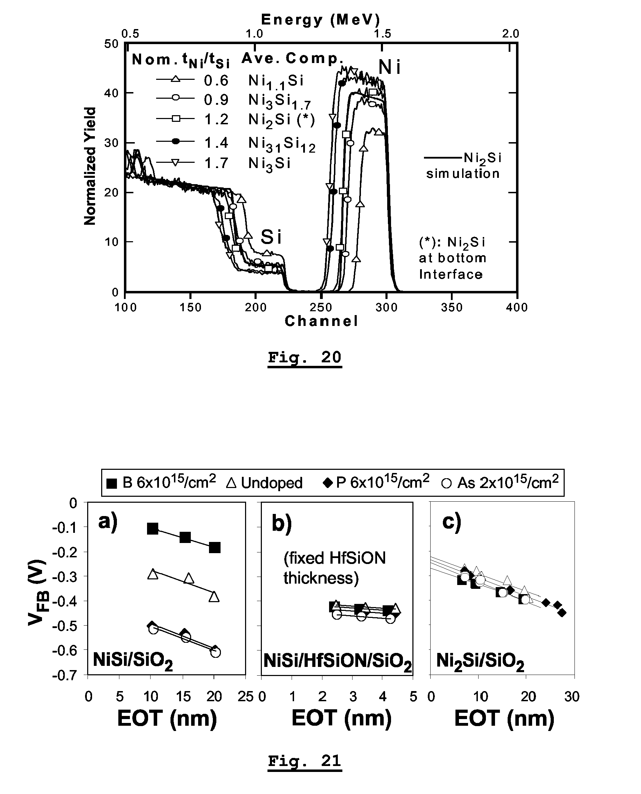

XRD patterns and RBS spectra after silicidation (and selective etch) for samples with deposited t_{Ni}/t_{Si} in the 0.6 to 1.7 range (100 nm poly-Si) are shown in Figs. 19 and 20 respectively. As for samples targeting NiSi, a slightly Ni-richer ratio rather than the exact stoichiometric ratio was used for samples targeting the different silicide phases. Fig. 19 shows that Ni-silicide phases with increasing Ni content are observed by XRD as the Ni/Si ratio is increased. As t_{Ni}/t_{Si} is increased above ~0.9, poly-Si is consumed with formation of Ni-rich silicide phases and NiSi does not form. For t_{Ni}/t_{Si} ~ 0.9 reacted at higher temperatures (HT), the presence of Ni₃Si₂ and Ni₂Si is observed by XRD (Fig. 19). Ni₂Si films were formed at t_{Ni}/t_{Si} ~ 1.2 (Figs. 19 and 20). The XRD patterns also indicate the presence of Ni₃₁Si₁₂ for this thickness ratio, particularly on samples reacted at higher temperatures (Fig. 19). The RBS spectra shown in Fig. 20 for t_{Ni}/t_{Si} ~ 1.2 indicates that the silicide film has a higher Ni content on the top portion and a composition of ~ Ni₂Si at the interface, suggesting a layered structure with the Ni-richer phase at the top for this case as well. Samples with a more uniform Ni₂Si composition could also be obtained (Fig. 18). For t_{Ni}t_{Si} ~ 1.4, the main phases present as determined from the XRD spectra are Ni₃₁Si₁₂ and Ni₃Si. At t_{Ni}/t_{Si} ~ 1.7, Ni₃Si films are formed (Figs. 19 and 20), with no indication of second phases in the XRD pattern. For self-aligned FUSI applications, phase control for Ni₃Si is not a significant problem, since this is the Ni-silicide phase with highest Ni content and in consequence it is stable in contact with Ni. Thus, the reaction reaches completion with formation of a uniform Ni₃Si layer and any excess Ni is then removed in the selective etch. Ni₃Si is the only phase obtained for reacted Ni to Si thickness ratios >1.6.

### Electrical characterization of Ni fully silicided gates.

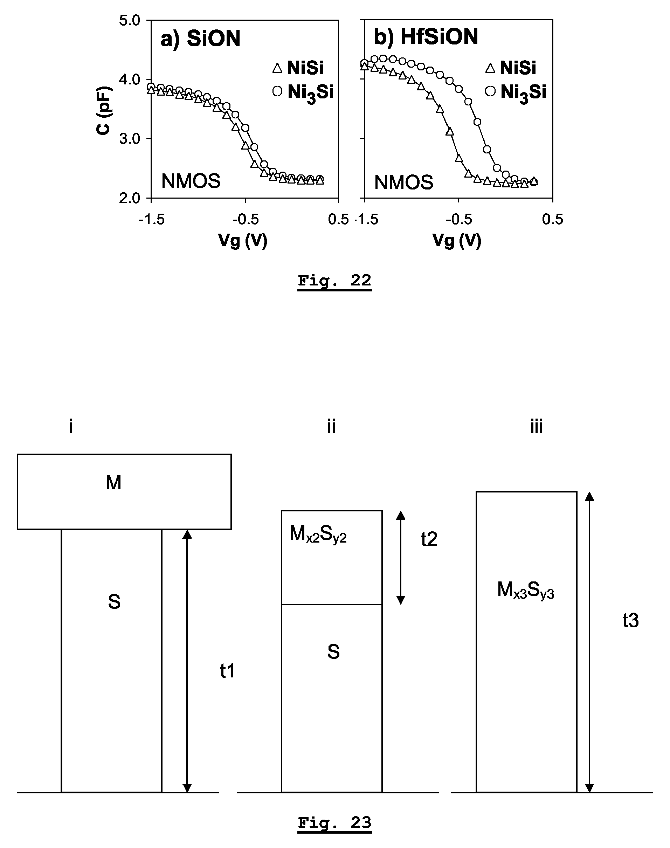

The WF of Ni FUSI gates was extracted from capacitance-voltage (CV) measurements performed on devices for several dielectric EOT values. A dual thickness series with HfSiON/SiO₂ stacks of varying SiO₂ and HfSiON thicknesses was used to evaluate the WF of NiSi on HfSiON, accounting for the effect of bulk charges in HfSiON. Figure 21 shows the dependence of the flat band voltage (V_{fb}) on EOT for NiSi/SiO₂, NiSi/HfSiON/SiO₂ and Ni₂Si/SiO₂ gate stacks, and the effect of dopants. Shifts in WF with dopants (-230 mV for As and +160 mV for B) are seen for NiSi on SiO₂. In contrast, dopant effects on WF are much smaller for NiSi on HfSiON (Fig. 21 (b)). The effective WF values extracted for undoped NiSi were ~4.72 eV on SiO₂ and ~4.5 eV on HfSiON. The lack of significant dopant effects and the WF value observed in this study for NiSi on HfSiON suggest that Fermi level pinning, previously reported for poly-Si gates on Hf containing high-K dielectrics, is still present for NiSi FUSI gates. Fig. 21 (c) shows that the WF of undoped Ni₂Si on SiO₂ (~4.7 eV) is quite similar to that of NiSi on SiO₂. However, in contrast to the case of NiSi, the WF of Ni₂Si on SiO₂ appears not to be affected significantly by the addition of dopants. Fig. 22 (a) shows that for Ni₃Si/SiON, an increase in V_{fb} of ~100 mV from the value for NiSi/SiON is obtained. The change in V_{fb} with silicide phase is quite larger for the case of HfSiON, with an increase of >300 mV from NiSi to Ni₃Si (Fig. 22 (b)), and suggests unpinning of the Fermi level with Ni₃Si.

The phases and morphology of Ni FUSI gates were studied for varying Ni to Si thickness ratios. The presence of NiSi₂, NiSi, Ni₃Si₂, Ni₂Si, Ni₃₁Si₁₂ and Ni₃Si as predominant phases was obtained for increasing Ni to Si ratios. A slightly Ni-richer thickness ratio than that corresponding to stoichiometric NiSi was found suitable for NiSi FUSI gate applications, resulting in a layered structure with NiSi at the interface and a Ni-rich silicide layer on top. No secondary phases were detected on Ni₃Si samples (Ni to Si thickness ratio ~ 1.7). Electrical characterization for NiSi, Ni₂Si and Ni₃Si devices on SiO₂, SiON and high-K dielectrics was performed. Only small changes in flat-band voltage or work function were found between these phases on SiO₂ or SiON for undoped samples. While significant changes in work function with dopants were observed for NiSi on SiO₂, little or no effects were found for NiSi on HfSiON (suggesting Fermi level pinning) and for Ni₂Si on SiO₂. An increase of > 300 mV was found from NiSi to Ni₃Si on HfSiON, suggesting unpinning of the Fermi level with the Ni-rich silicide.

A method according to the present invention comprises selecting parameters of first thermal step to control diffusion of metal into semiconductor such that the (total) amount of metal present in the silicided portion of the semiconductor gate electrode is well-controlled and the ratio metal-to-semiconductor is larger than 1.

Preferably the metal is the moving species silicidation process and the pile-up of metal in the semiconductor is controlled.

Preferably abundant metal is present during the first thermal step and hence no metal shortage is likely to occur which would impact the amount of metal incorporated in the semiconductor gate electrode during the first thermal step.

Preferably the semiconductor gate electrode has limited dimensions, i.e. it is not a complete substrate. Consequently all semiconductor material of the gate electrode will be consumed during complete silicidiation. In case of a gate electrode the semiconductor gate constitutes a container for accepting the metal and the whole container can take part in the overall silicidation process.

The process parameters of the silicidation process can be determined as described herein and/or as illustrated in figure 23.

Figure 23(i) shows the stack of unreacted metal M and semiconductor gate electrode S. For simplicity the sidewall spacers adjacent to the gate electrode and the source/drain regions present in the substrate on which the gate is formed are not shown.

Figure 23(ii) shows the partially silicided gate electrode after the first thermal step and after having selectively removed the unreacted metal M.

Figure 23(iii) shows the fully silicided gate electrode after the second thermal step.

A method according to the invention can further comprise:
- selecting the metal phase Mₓ₃S_{y3} in the fully silicided semiconductor gate (x₃, y₃ or in other words the total amount of metal present in the semiconductor gate electrode) with a given thickness;
- optionally selecting the total thickness of the fully silicided gate t₃ and hence the thickness of the unsilicided semiconductor gate.

The correlation between the thickness of the fully silicided gate electrode (t₃), and the thickness of the unsilicided semiconductor gate (t₁), can be made if the metal phase Mₓ₃S_{y3} is determined.

As shown, each silicidation phase is characterized by a certain volume expansion coefficient as is known from M.A. Nicholet et al in "VLSI electronics: Microstructure Science Vol. 6", editors N.G. Einspruch and G. B. Larrabee, Academic Press, New York 1983, pages 455 to 459. If there is abundant metal available one can in first instance say: t₃ = expansion coefficient * t₁. Consequently the thickness t₁ is determined.

The total amount of metal in the fully silicided gate is the amount of metal that has to be stored in the partially silicided semiconductor gate during the first thermal step. Hence after the first thermal step a metal-rich silicide phase is to be formed.

After this first thermal step the only metal available for the use in the second thermal step is the amount of metal incorporated in the semiconductor gate during the first thermal step. In the second thermal step only a redistribution of this incorporated amount of metal will occur.

The parameters of the first thermal step can be determined by establishing a graph indicating how much metal diffuses into the semiconductor gate electrode for a given time and temperature. The suitable time and temperature settings are thus selected such as to have the necessary amount of metal incorporated in a part of the semiconductor gate.

In first instance this amount of metal can be regarded as proportional to t₃*x₃ and to t₂*x₂. By selecting x₂ and t₂ with x₂ > x₃ and t₂ < t₃, the phase Mₓ₂S_{y2} and the thickness of the silicided portion t₂ can be determined.

To be more accurate, the total number of metal atoms available before and after the first thermal step can be compared.

Figures such as figure 6 can be used for each silicide phase Mₓ₂S_{y2}, since such figures are representative of the amount of metal (x₂*t₂) that can be stored for a given time temperature combination with only thickness t₂ as parameter.

In a method according to the invention, for every metal and for every metal-semiconductor phase envisaged for forming a fully silicided gate electrode, curves (silicidation kinetics graphs) similar to figure 6 can be made (established).

Such curves can be made by any person skilled in the art using known experimental techniques: select a metal, deposit the selected metal with on a semiconductor substrate, vary time and temperature of the first thermal step and measure the phase x₂, y₂ and the thickness t₂ of the thus formed silicide phase.

Figure 14 shows the result of the second thermal step.

In case a fully silicided gate electrode with Mₓ₃S_{y3} with x3=y3=1 is envisaged, e.g NiSi, at least at the interface between the fully silicided gate electrode and the gate dielectric:
- if the first thermal step lasts to long, too much metal will diffuse into the semiconductor gate electrode and will be incorporated such that t₂*x₂ > t₃*x₃. Hence a metal rich silicide will be formed.
- If the first thermal step is not long enough, insufficient amount of metal t₂*x₂ < t₃*x₃ is incorporated in the partial silicided semiconductor gate electrode. Consequently after redistribution the semiconductor gate electrode might not be completely silicided.

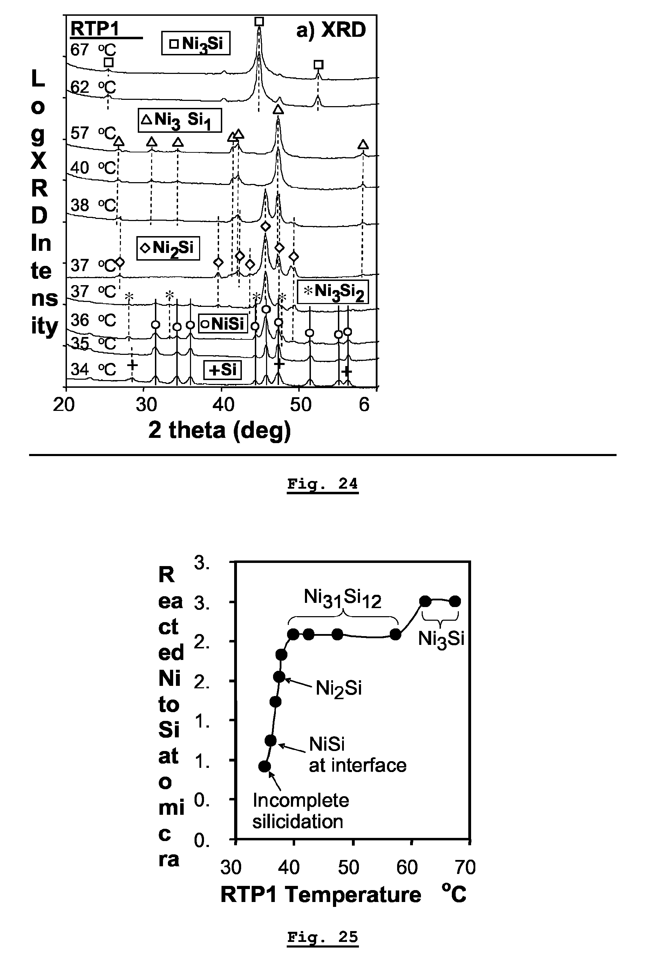

Figure 24 shows the crystallographic characterization of silicide films manufactured using a manufacturing process as illustrated by figure 5.

The silicide films are characterized using X-ray Diffraction (XRD).

These fully silicided gates are obtained by depositing 170nm of nickel on 100 nm polycrystalline silicon, such that the silicidation reaction is not limited by the supply of the refractory metal, in this example nickel.

The gate dielectric is a hafnium-siliconoxide-nitride dielectric. The two-step thermal process is performed using an ASM Levitor RTP system.

The temperature of the first thermal step (RTP1) is varied from about 340°C to about 675°C. The time of this first thermal step was set at about 30s.

A selected etch is performed to remove unreacted nickel after the first thermal step.

Thereafter a second thermal step (RTP2) is executed at 480°C for about 30s.

It is found that when the reaction is not limited by the availability of nickel, the resulting silicide phase of a fully silicided polysilicon gate can be effectively controlled by the thermal budget of the first thermal step (RTP1).

Within the conditions set for figure 24 in terms of thicknesses (170nm Ni / 100nm poly-Si) and time (30 seconds), for RTP1 temperatures less than or equal to 350°C, the polysilicon gates are not fully silicided (even if abundant nickel is present).

Poly-Si (+Si) X-ray Diffraction (XRD) peaks are observed as shown in figure 24. From 350°C onwards complete silicidation of the 100nm polysilicon gate can occur.

For RTP1 temperatures in the range of 355°C to 375°C, XRD shows the presence of various nickel silicide phases in the fully silicided gate.

Figure 24 illustrates the nickel silicide phases present in the fully silicided gate electrode for first thermal temperatures of respectively 360°C, 370°C and 375°C: NiSi (open circles), Ni₃Si₂ (stars) and Ni₂Si (open diamonds) phases are formed.

Rutherford Backscattering Spectrometry (RBS) and Transmission Electron Microscopy (TEM) analysis showed that the thus-obtained fully silicided films have a layered structure with the metal-poor phase, in this case NiSi, at the bottom of the fully silicided gate electrode (7) in contact with the underlying gate dielectric (6) (i.e. at the interface), while the metal-rich silicides, in this case Ni₃Si₂ and Ni₂Si, are in the upper part of the fully silicided gate electrode.

The work function of these gate electrodes will thus be determined by the NiSi phase at the interface.

Within the conditions set for figure 24, the RTP1 temperature process window for forming NiSi, at least at the interface, is about 20°C or less.

Within the conditions set for figure 24, the process window of the first thermal step (RTP1) for forming Ni₂Si at least adjacent the gate dielectric (7) (i.e. at least at the interface) is 25°C or less.

If the temperature of the first thermal step (RTP1) is above 400°C, Ni₃₁Si₁₂ will start to grow. In the temperature range from about 400°C to about 600°C a fully silicided gate electrode will be formed during the first thermal step where essentially only a Ni₃₁Si₁₂ phase can be detected. Figure 24 shows fully silicided gate electrodes formed respectively at RTP1 temperatures of 400°C and 575°C only exhibiting Ni₃₁Si₁₂ XRD peaks (open triangle).

If the temperature of the first thermal step (RTP1) is above 625°C, Ni₃Si will start to grow. In a temperature range above about 625°C a fully silicided gate electrode will be formed during the first thermal step where essentially only a Ni₃Si phase can be detected. Figure 24 shows fully silicided gate electrodes formed respectively at RTP1 temperatures of 625°C and 675°C only exhibiting Ni₃Si XRD peaks (open squares). The RTP1 temperature process window to form Ni₃₁Si₁₂, at least at the interface, is about 200°C.

The method of controlling the phase formation for a fully silicided gate electrode is illustrated by figure 25 using the experimental results in relation with Fig. 24 for the example of nickel silicide.

The Ni to Si reacted ratio is controlled by the thermal budget of the first RTP step (RTP1) which thermal budget is determined by its time and temperature. In figure 25, the time is kept constant at 30s, while the temperature of the first thermal step is varied to vary the thermal budget thereof.

At low RTP1 thermal budgets, i.e. below 350°C, insufficient Ni has reacted, at least for transistors having a large gate lengths, e.g. 100nm or above, and the polycrystalline silicon gate electrode remains incompletely silicided even after performing a second thermal step RTP2.

In the thermal budget range associated with the RP1 temperature range 350°C to 375°C sufficient Ni has reacted to result in a full silicidation of the gate electrode after RTP2 with NiSi in contact with the gate dielectric (7) (i.e. at the interface) for gate lengths above and below 100nm.

In the thermal budget range associated with the RP1 temperature range 375°C to 400°C sufficient Ni has reacted to result in a full silicidation of the gate electrode after RTP2 with Ni₂Si in contact with the gate dielectric (7) (i.e. at the interface) for gate lengths above and below 100nm.

In the thermal budget range associated with the RP1 temperature range 400°C to 600°C sufficient Ni has reacted to result in a full silicidation of the gate electrode after RTP2 with Ni₃₁Si₁₂ in contact with the gate dielectric (7) (i.e. at the interface) for gate lengths above and below 100nm.
In the thermal budget range associated with the RP1 temperature range above 600°C sufficient Ni has reacted to result in a full silicidation of the gate electrode after RTP2 with Ni₃Si₁ in contact with the gate dielectric (7) (i.e. at the interface) for gate lengths above and below 100nm.

## Claims

1. A method of manufacturing a fully-silicided-gate electrode in a semiconductor device, comprising the steps of:
- depositing a metal layer over a semiconductor layer of a gate stack,
- providing a first thermal budget to allow a partial silicidation of said semiconductor layer, whereby the silicide layer obtained has a ratio metal-to-semiconductor higher than 1,
- removing selectively the remaining, unreacted metal layer, and
- providing a second thermal budget to allow a full silicidation of said semiconductor layer.

2. A method according to claim 1, wherein said semiconductor layer comprises silicon and/or germanium.

3. A method according to claim 1 or 2, wherein said semiconductor layer comprises (or consists of) poly-silicon (poly-Si).

4. A method according to any of claims 1 to 3, wherein said metal layer comprises (or consists of) any suitable refractory metal, noble metal, transition metal, or any combination thereof.

5. A method according to claim 4, wherein said metal layer comprises (or consists of) Ni.

6. A method according to any of claims 1 to 5, wherein said first thermal budget is determined by a silicidation kinetics graph drawn up for each silicide phase, MₓS_{y}, envisaged in the partially silicided gate, wherein M represents said metal and S said semiconductor used, and wherein x and y are real numbers different from 0 and higher than 0.

7. A method according to claim 6, wherein said silicidation kinetics graph is represented by figure 6.

8. A method according to any of claims 1 to 7, wherein the step of providing said first thermal budget consists of an Rapid Thermal Processing (RTP).

9. A method according to any of claims 1 to 8, wherein the step of providing said second thermal budget consists of an RTP.

10. A method according to any of claims 1 to 9, wherein the step of removing said remaining metal layer consists of a selective etching.

11. A method according to any of claims 1 to 9, wherein said metal layer consists of Ni and said semiconductor layer consists of poly-Si.

12. A method according to claim 11, wherein said first thermal budget is such that a Ni₂Si layer is grown, with a thickness comprised between 0,9 and 1,5 of the poly-Si thickness, whereby a NiSi FUSI gate is obtained.

13. A method according to claim 12, further comprising the step of drawing up a silicidation kinetics graph for Ni₂Si, whereby the temperature and time period to apply as said first thermal budget is determined.

14. A method according to claim 13, wherein said silicidation kinetics graph is represented by figure 6.

15. A method of manufacturing a fully-silicided-gate electrode in a MOSFET device, comprising the steps of:
- depositing a nickel layer over a poly-Si layer of a gate stack,
- providing a first thermal budget to allow a partial silicidation of said poly-Si layer, whereby the silicide layer obtained has a ratio Ni/Si higher than 1,
- removing selectively the remaining, unreacted metal layer, and
- providing a second thermal budget to allow a full silicidation of said semiconductor layer.

16. A method according to claim 15, wherein said first thermal budget is determined by a silicidation kinetics graph drawn up for each silicide phase, NiₓSi_{y}, envisaged in the partially silicided gate, wherein x and y are real numbers different from 0 and higher than 0 and wherein 1<x/y≤3.

17. A method according to claim 15 or 16, wherein the step of providing said first thermal budget consists of an RTP.

18. A method according to any of claims 15 to 17, wherein the step of providing said second thermal budget consists of an RTP.

19. A method according to any of claims 15 to 18, wherein the step of removing said remaining metal layer consists of a selective etching.

20. A method according to any of claims 16 to 19, wherein said first thermal budget is such that a Ni₂Si layer is grown, with a thickness comprised between 0,9 and 1,5 of the poly-Si thickness, whereby a NiSi FUSI gate is obtained.

21. A method according to claim 20, further comprising the step of drawing up a silicidation kinetics graph for Ni₂Si, whereby the temperature and time period to apply as said first thermal budget is determined.

22. A method according to claim 21, wherein said silicidation kinetics graph is represented by figure 6.

23. A method according to any of claims 15 to 22, wherein said poly-Si layer is upon a SiON or upon a HfSiON layer.
